# EUROPEAN PATENT SPECIFICATION

(11) **EP 1 494 299 B1**
(45) Date of publication and mention of the grant of the patent: **28.05.2008**
(21) Application number: 04253853.8
(22) Date of filing: 28.06.2004
(51) Int. Cl.: H01M 2/10

(54) **Electronic equipment and method for extracting battery or electronic component thereof**
Elektronische Ausrüstung und Verfahren um daraus eine Batterie oder eine elektrische Komponente herauszuziehen
Dispositif éléctronique et procédé d'extraction d'une batteire ou d'un composant électrique dudit dispositif

(30) Priority: 30.06.2003 JP 2003188424
(43) Date of publication of application: 05.01.2005
(73) Proprietor: Sony Corporation, Tokyo 141-0001 (JP)
(72) Inventor: Amatatsu, Seiya, Shinagawa-ku Tokyo 141-0001 (JP); Takahashi, Nobutatsu, Shinagawa-ku Tokyo 141-0001 (JP)
(74) Representative: Smith, Samuel Leonard

(56) References cited:
- DE-B- 1 132 201
- US-A- 5 552 240
- PATENT ABSTRACTS OF JAPAN vol. 014, no. 125 (E-0900), 8 March 1990 (1990-03-08) & JP 01 319247 A (CANON INC), 25 December 1989 (1989-12-25)
- PATENT ABSTRACTS OF JAPAN vol. 012, no. 291 (E-644), 9 August 1988 (1988-08-09) & JP 63 066847 A (SEIKO EPSON CORP), 25 March 1988 (1988-03-25)
- PATENT ABSTRACTS OF JAPAN vol. 1999, no. 04, 30 April 1999 (1999-04-30) & JP 11 016552 A (SANYO ELECTRIC CO LTD), 22 January 1999 (1999-01-22)

## Description

The present invention relates to a structure of extracting a battery incorporated in electronic equipment and a method for extracting a battery or an electric component.

Conventionally, a cadmium cell and a lead battery have been used as secondary batteries incorporated in a portable CD player, MD player, DVD recorder, digital camera, camcorder, telephone unit, PDA and other portable electronic equipment, and it is stipulated by laws regarding recycling that the batteries need to be extracted and separated before disposing of equipment incorporating those secondary batteries.

In addition, a method for easily changing a primary battery or a secondary battery by a user has been in demand.

As described above, various extracting structures of electronic equipment capable of changing and extracting primary and secondary batteries have conventionally been proposed, and the applicant of the present invention proposed a structure prior to this application, in which a secondary battery is electrically connected to a flexible board having an elasticity on which a breaking piece portion that is easily broken is provided to attach the secondary battery, and when the secondary battery is removed, the breaking piece portion is cut to be discarded with the battery.

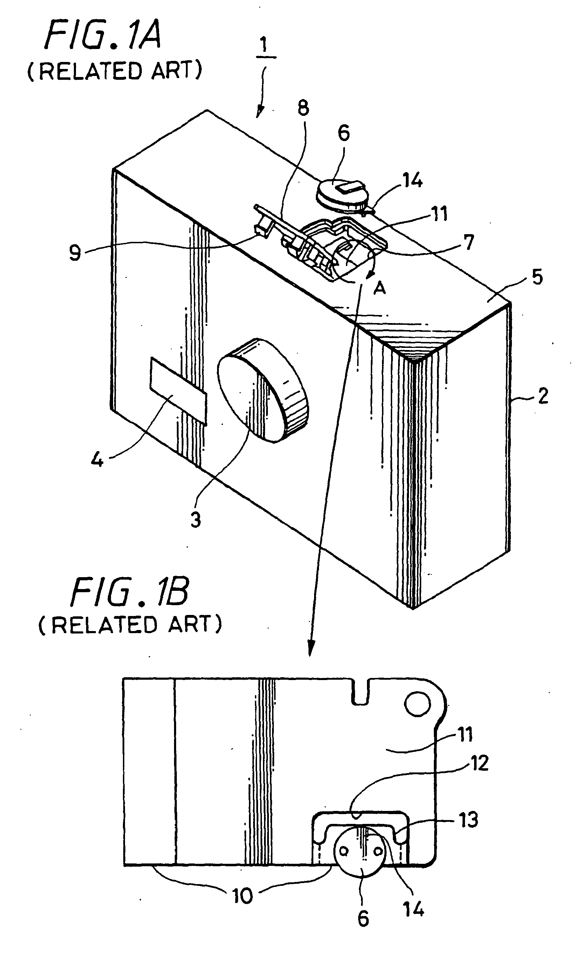

FIG. 1A is a view showing a digital still camera 1 disclosed in the above prior application, in which an opening 7 that accommodates a secondary battery 6 is provided at the bottom portion 5 of a casing 2 having a lens body 3 constituting a lens portion and a flash window 4 on the front surface thereof, and a lid 8 is engaged and locked with the opening 7 by means of an engaging hook 9.

Inside the opening 7, as shown in FIG. 1B that is an enlarged view of a portion A of FIG. 1A, a reinforcement board 11 is stuck on a flexible board 10, having a cut-off portion 12 formed to show the flexible board 10 and a groove 13 formed to mount the secondary battery 6 on a breaking piece portion 14, and when this digital still camera is discarded, the secondary battery 6 is bent to cut the breaking piece portion 14 off the camera body, so that the secondary battery 6 is separated to be disposed of.

In the above described electronic equipment, a screwdriver or the like is required to open the lid 8, and the breaking piece portion 14 accommodated in the casing 2 needs to be held up and cut by the user's hand to be extracted from the casing 2, as shown in FIG. 1A. Therefore, three steps of actions: first removing the lid 8, holding up the breaking piece portion 14 of the flexible board 10 to be cut, and then taking out the secondary battery 6 are required. In order to perform the action of holding up the breaking piece portion 14 to cut the flexible board 10, the opening 7 needs to have a predetermined space and the large opening area, and in addition, the opening 7 must be provided on any one surface of the six surfaces of the casing 2.

In light of the above problems, the present invention is proposed to obtain electronic equipment, in which the opening area of the opening 7 is sufficiently small, the opening 7 can be provided inside the casing instead of being provided on any one of six surfaces, and the two steps of actions of extracting the secondary battery and of cutting thereof are combined to be performed by one action, and a method for extracting a battery or an electric component from the electronic equipment.

In electronic equipment and a method for extracting a battery or electric component from the electronic equipment according to the present invention, a sub board on which a battery is mounted is separately provided from a main board to be joined by a strip-shaped elastic connecting member, and only the battery is pulled out from a casing of the electronic equipment.

According to an aspect of the present invention, electronic equipment is provided as defined in the claims.

According to an embodiment of the present invention, electronic equipment in which a battery is extracted through an opening provided on a part of a casing or a chassis includes: a main board connected to a battery, a strip-shaped elastic connecting member that joins the main board with the battery, a sub board, on which the battery is set, connected to the strip-shaped elastic connecting member, and a lid or main board to engage and lock the sub board, in which by opening the lid of the opening, the battery on the sub board is pulled out of the opening from the main board through the strip-shaped elastic connecting member.

According to an aspect of the present invention, in a method for extracting a battery or electric component from electronic equipment in which the battery is extracted through an opening provided on a part of a casing or chassis, a sub board, on which the battery or electric component is mounted, provided on one end of a strip-shaped elastic connecting member joined with a main board is connected to a lid or the main board, and by removing the lid that closes the opening, the battery or electric component as well as the sub board is pulled out of the opening from the main board through the strip-shaped elastic connecting member.

According to an aspect of the present invention including the electronic equipment and the method for extracting a battery or electric component from the electronic equipment, a secondary battery used for backup can be extracted only by one action of removing the lid, and only by pulling the sub board, on which the secondary battery is mounted, out of the casing or the lid, the secondary battery is separated from the main board to be disposed of. Further, the opening can be small-sized, and is arranged inside the casing without providing the opening on any of the six surfaces, so that there is no possibility of opening the lid by accident, and is much choice in selecting the design of the casing, because no lid is provided on the six surfaces of the casing.

The invention will now be described, purely by way of example, with reference to the Figures, in which:
FIGS. 1A and 1B are perspective views for explaining a conventional method for accommodating a battery in electronic equipment;
FIG. 2 is a schematic perspective view showing an embodiment of a method for extracting a battery from electronic equipment according to the present invention;
FIG. 3 is a schematic perspective view showing an embodiment of the joined state of a lid of electronic equipment according to the present invention;
FIG. 4 is a perspective view showing the outer appearance of an embodiment of electronic equipment according to the present invention;
FIG. 5 is a plan view of the left side surface of the electronic equipment of FIG. 4 shown in the direction of an arrow A;
FIG. 6 is a perspective view for explaining the state in which a battery of the electronic equipment according to an embodiment of the present invention is extracted;
FIGS. 7A and 7B are views for explaining the state in which a battery of the electronic equipment according to an embodiment of the present invention is extracted, in which FIG. 7A is a plan view and FIG. 7B is a perspective view of the main board;
FIG. 8 is a lateral cross-sectional view showing the state in which a battery of an embodiment of the electronic equipment of the present invention is accommodated;
FIG. 9 is a perspective view for explaining a method according to an embodiment of the present invention, in which a battery is temporarily fixed;
FIG. 10 is a perspective view for explaining a method according to an embodiment of the present invention, in which a battery is fixed to the lid; and
FIG. 11 is a perspective view for explaining the assembled state of the electronic equipment according to an embodiment of the present invention.

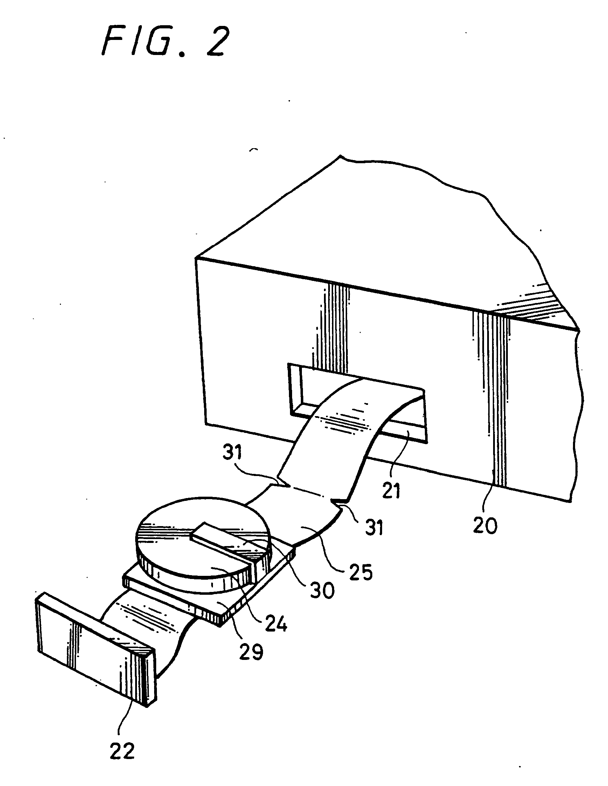

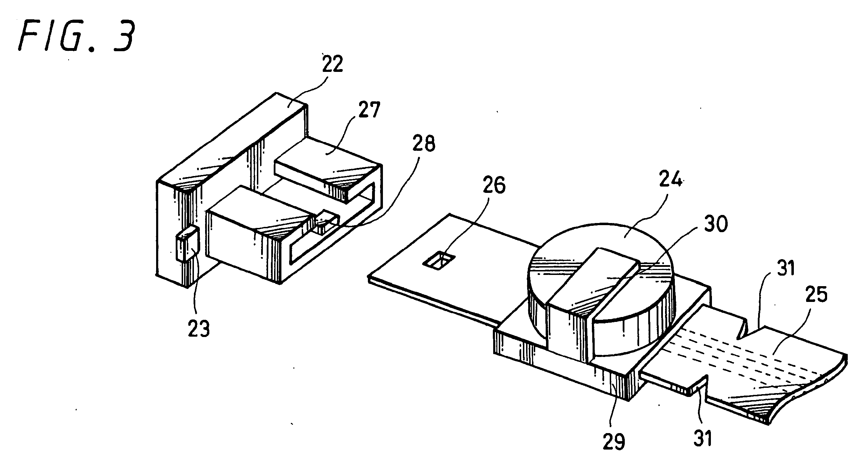

Hereinafter, an embodiment of a method for extracting a battery from electronic equipment according to the present invention will be explained with reference to FIGS. 2 and 3. FIG. 2 is a perspective view showing the state in which a battery is extracted from electronic equipment, and FIG. 3 is a perspective view showing the state in which a sub board on which the battery is mounted is joined with the lid.

In FIGS. 2 and 3, numeral 20 denotes a casing of the above described various devices such as a digital camera, a portable camcorder or the like, on the bottom surface of which a rectangular opening 21 is provided to be continuously closed by a lid 22 using an engaging hook 23 shown in FIG. 3.

Although not shown in the drawings, a main board such as a clock circuit driven by a backup battery 24 is disposed in the casing 20, to one end of which a strip-shaped elastic connecting member 25 such as a flexible board or flexible cable is connected by integrally forming, soldering, using a flat connecter or using other methods.

As shown in FIG. 3, at the other end of the strip-shaped elastic connecting member 25 an engaging hole 26 is bored, with which an engaging piece 28 formed on a guide portion 27 that is integrally formed with the lid 22 on the rear surface thereof is engaged, so that the strip-shaped elastic connecting member 25 is fixed to the lid 22 so as not to be disengaged.

A sub board 29 in approximately square shape is joined with the strip-shaped elastic connecting member 25 at the position adjacent to the lid 22 using adhesive or the like; the battery 24 is pressed to be held by an L-shaped pressurizing portion 30 having spring force, which is fixed to the sub board 29; and the voltage of both electrodes of the battery 24 is output to the clock circuit or the like through the sub board 29 and strip-shaped elastic connecting member 25. Further, notches or a perforated line 31 is formed on the strip-shaped elastic connecting member 25 at a position for example close to the sub board 29, so that when the lid 22 is pulled with force, the strip-shaped elastic connecting member 25 is cut at the position between the notches.

In the case where the above strip-shaped elastic connecting member 25 is formed of a flexible board, the sub board 29 may be a reinforcement member made of plastic, for example.

Further, with respect to the state in which the battery 24 and strip-shaped elastic connecting member 25 are accommodated in the casing 20, the sub board 29 may be temporarily retained, or the strip-shaped elastic connecting member 25 may be stored with slack.

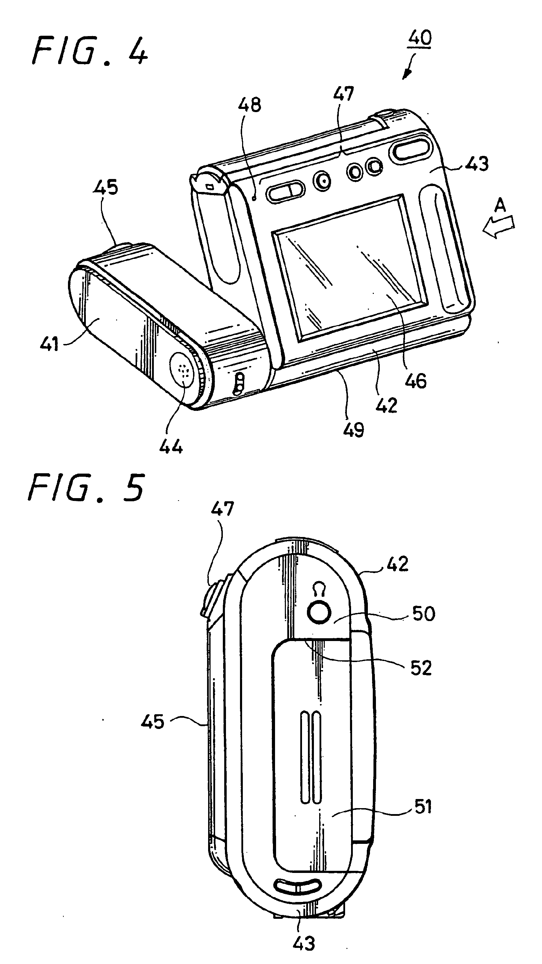

Next, another embodiment of the present invention will be described in detail with reference to FIGS. 4 through 11. FIG. 4 is a perspective view showing electronic equipment to which the battery extracting structure of the present invention is applied, and FIG. 5 is a lateral view showing the right side surface of a casing, where an opening to insert the battery is provided.

Electronic equipment 40 shown in FIGS. 4 and 5 includes a camera unit 41 as an image pick-up unit and a main unit 42 incorporating a recording-medium driving unit such as HDD (hard disc drive) unit or the like in which a picked-up image and audio data can be recorded and reproduced.

The camera unit 41 is mounted on an axis 44 arranged at the lower side of the casing 43 of the main unit 42 so that the camera unit 41 can pivot. A lens 45 is provided in the camera unit 41, and the lens 45 can be set at a predetermined position within the range of 180° from the front side to the rear side.

On the front surface (panel) side of the main unit 42, a display 46 such as an LCD and various operation keys 47 are provided, a thin-type HDD unit (not shown) is provided approximately in parallel with the display 46, and an LED 48 and the like for the access to the HDD are provided on the left side of the various operation keys 47, to be capable of monitoring the state of access to the HDD unit from the outside of the main unit 42.

Further, by engaging a semi-circular portion 49 of the main unit 42 with a semi-circular depression of a cradle (not shown), electric connection is established and data is input from and output to CPU, CRT and the like through an image terminal, audio terminal, USB (Universal Serial Bus) terminal of the cradle.

FIG. 5 is a plan view of FIG. 4 seen in the direction of an arrow A, and on a left side surface board 50 of a casing 43 of the main unit 42, an opening 52 in an approximately rectangular shape capable of inserting a primary battery is formed and a lid 51 is attached to fit and close the opening 52.

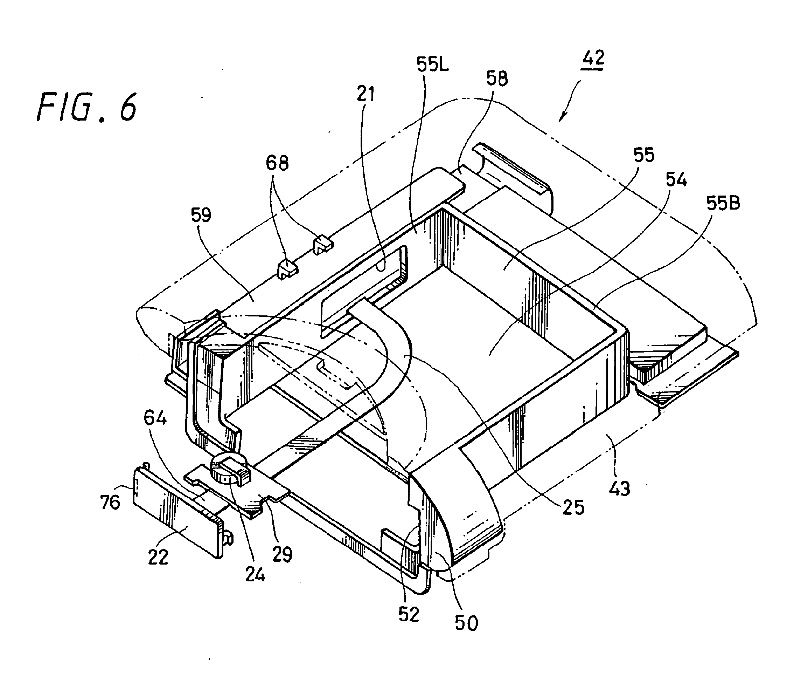

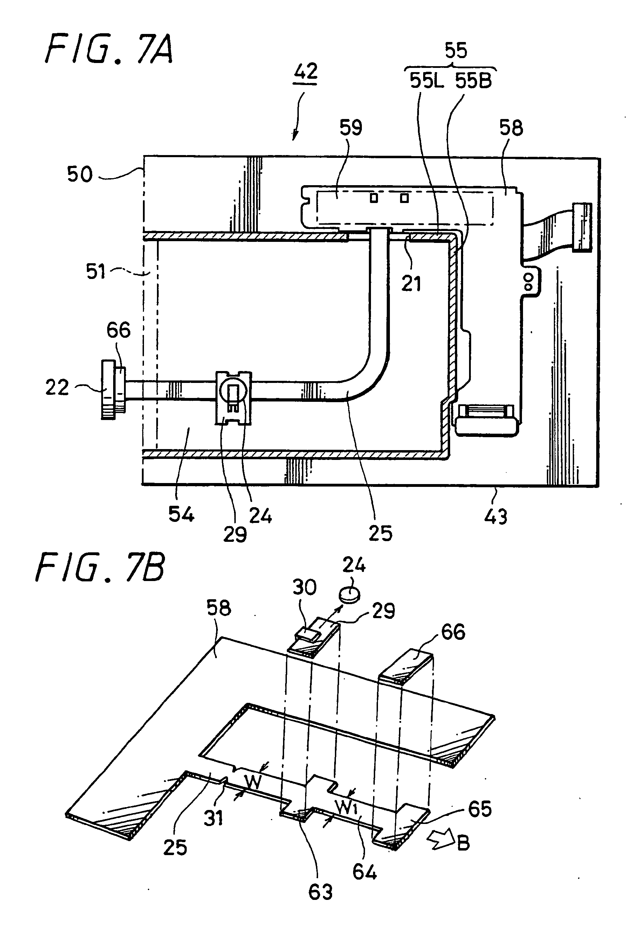

FIG. 6 is a perspective view of the rear surface side facing upward of the casing 43 opposite to the display 46 side in FIG. 5, showing the state in which the primary or secondary battery for the backup is extracted, and FIG. 7A is a schematic plan view of FIG. 6, showing the inside of the casing 43 in which a primary battery accommodating portion 54 is provided along the opening 52 of the left side surface board 50 and an approximately rectangular parallelepiped shaped space is formed.

An opening 21 capable of accommodating the second battery 24 for the backup is formed on the left side board 55L of an approximately U-shaped frame member 55 constituting the primary battery accommodating portion 54. On the outside of the rear board 55B and the left side board 55L constituting the frame member 55, an approximately L-shaped main board 58 is provided as shown in FIGS. 7A and 7B, on which a clock circuit and other circuit patterns are formed.

As shown in the perspective view of FIG. 7B, a flexible printed circuit (hereinafter described as FPC) is used as the above main board 58. In this embodiment, the main board 58 and the strip-shaped elastic connecting member 25 are integrally formed with FPC. Specifically, the main board 58, a strip-shaped elastic connecting member 25, a sub board mounting portion 63, a strip-shaped elastic member 64, and a dummy board mounting portion 65 are punched out integrally, in which patterning is executed on a predetermined one surface or both the surfaces of the main board 58, strip-shaped elastic connecting member 25, and sub board mounting portion 63.

Further, the width W of the strip-shaped elastic connecting member 25 is selected to be narrower than the width W1 of the strip-shaped elastic member 64, so that when the dummy board mounting portion 65 is pulled in the direction of an arrow B, the strip-shaped elastic connecting member 25 is first cut. Alternatively, notches 31 may be provided on the strip-shaped elastic connecting member 25 side, or a perforated line may be provided other than a wiring portion, so that the strip-shaped elastic connecting member 25 can be cut off by a predetermined tensile force.

On the sub board mounting portion 63, an approximately rectangular shaped sub board 29 made of a printed circuit or synthetic resin member having a pressurizing portion 30 is joined. In addition, a dummy board 66 that is a later described connecting member to a lid 22 is joined to the dummy board mounting portion 65 through adhesive or the like.

In the above structure, the strip-shaped elastic connecting member 25 is composed of FPC; however, a flexible flat cable (hereinafter described as FFC) such as a rectangular conductor flat cable or the like may also be used. Further, the portion of the strip-shaped elastic member 64 may be a metal plate, plastic board, FFC, FPC, or the like having elasticity.

Furthermore, the sub board 29 and the sub board mounting portion 63 made of FPC are separately provided; however, the relevant portion may be formed of a FPC multiple structure in which the secondary battery is directly soldered without using the pressurizing portion 30.

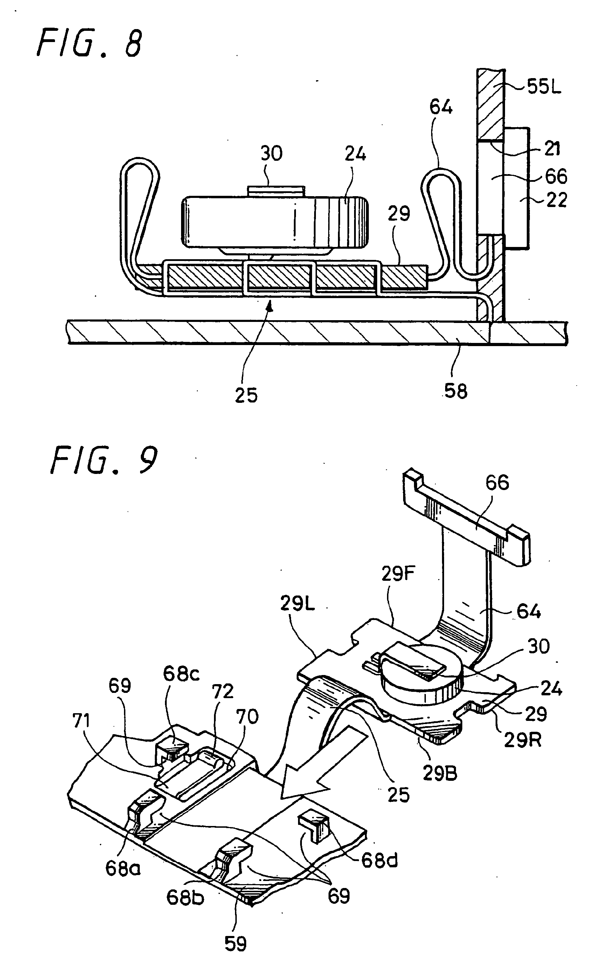

FIG. 8 is a lateral cross-sectional view showing the state in which the sub board 29 is accommodated inside the left side board 55L of the frame member 55 of the casing 43. As shown in FIG. 8, the above described dummy board 66, the strip-shaped elastic connecting member 25 on which the sub board 29 is mounted, and the strip-shaped elastic member 64 may be freely placed in a folded state; however, the sub board 29 may be temporarily locked onto a temporarily locking portion 59 to lock the dummy board 66 on the lid 22, as shown in FIGS. 9 through 11.

FIG. 9 shows the state in which the secondary battery 24 held on the sub board 29 by the pressurizing portion 30 is temporarily locked on the temporarily locking portion 59 provided on the main board 58, and four pieces of engaging hook 68a, 68b, 68c, and 68d having an approximately L-shaped cross section are projected on the temporarily locking portion 59 of synthetic resin molded board.

The engaging hooks 68a and 68b are projected with L-shaped slits 69 in the front direction so as to engage with the rear side portion 29B of the sub board 29, and the engaging hooks 68c and 68d are projected with the L-shaped slits 69 in the right and left direction so as to engage with the right and left side portions 29R and 29L of the sub board 29.

Further, a through hole 70 in an approximately rectangular shape is formed in the temporarily locking portion 59, in which a reed-like engaging piece 71 integrally formed with the temporarily locking portion 59, supported by one end thereof, and giving the upward lopsided force is provided with a projecting portion 72 on the tip thereof.

Accordingly, when in FIG. 9 the sub board 29 is slid in the direction of an arrow C toward the slits 69 of the engaging hooks 68a, 68b, 68c, and 68d with the strip-shaped elastic connecting member 25 folded under the sub board 29, the reed-like engaging piece 71 is pressed. However, when the sub board 29 is completely fit into the engaging hooks 68a, 68b, 68c, and 68d, the projecting portion 72 of the reed-like engaging piece 71 is fit to a front side portion 29F of the sub board 29 to serve as a stopper.

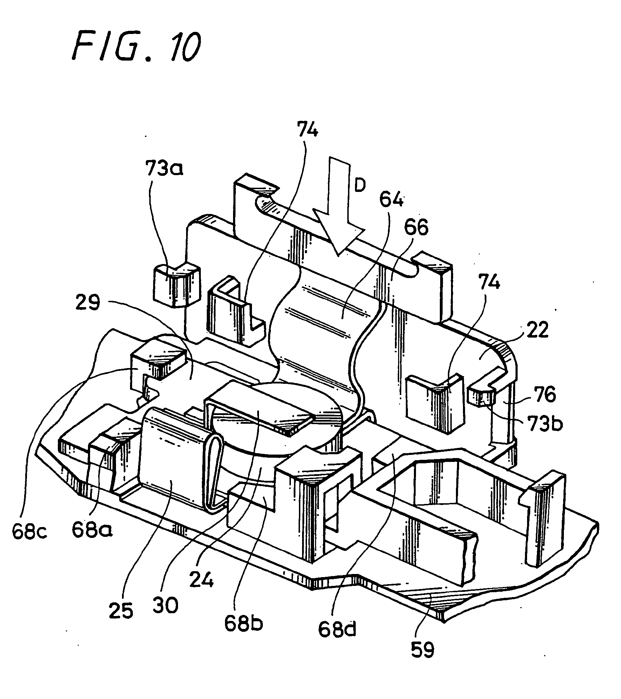

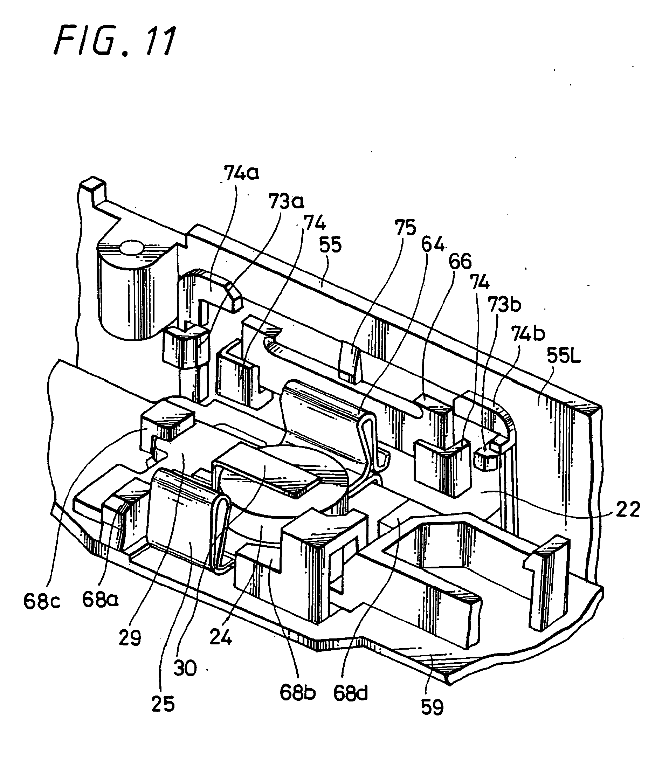

FIGS. 10 and 11 show the state in which the sub board 29 is inserted into the engaging hooks 68a, 68b, 68c, and 68d.

Next, a method for fitting the dummy board 66 within the lid 22 is explained with reference to FIGS. 10 and 11.

As shown in FIG. 10, approximately L-shaped engaging hooks 73a and 73b-are projected on the rear surface of the lid 22. Those engaging hooks 73a and 73b are as shown in FIG. 11 engaged with locking portions 74a and 74b formed on the rear side of the left side board 55L of the frame member 55. In addition, a recess 76 is formed on the right end portion of the lid 22.

Further, engaging portions 74 capable of regulating the position of the dummy board 66 by the lower end and in the right and left direction to be locked is formed on the rear surface of the lid 22, and in addition as shown in FIG. 11, a stopper 75 that regulates the upward movement of the dummy board 66 inserted into the engaging portions 74 is provided.

Accordingly, when as shown in FIG. 10 with an arrow D the dummy board 66 is fitted to and engaged with the engaging portions 74 of the lid 22, the dummy board 66 is fixed to the lid 22 by the stopper 75, as shown in FIG. 11. Therefore, in normal conditions the secondary battery 24 is fixed on the temporarily locking portion 59 in the temporarily locked state.

In a method for extracting a battery or electric component from electronic equipment according to the present invention, when the end of a tool having a pointed tip such as a pair of tweezers or a flat head is inserted into the recess 76 formed on the right side end of the lid 22 from the opening 52 for the primary battery accommodating portion 54 provided in the casing 43 of the main unit 42 of the electronic equipment 40 and the lid 22 is unclenched from the opening 21 to open, the sub board 29, on which the battery 24 joined with the strip-shaped elastic member 64 is mounted, pulled out with the dummy board 66 fixed to the lid 22 climbs over a projecting portion 72 of the engaging piece 71 temporarily fixed and can be extracted from the opening 52 of the casing 43 through the space of the battery accommodating portion 54 as shown FIGS. 6 and 7A.

Under the above condition, when the sub board 29 is pulled with force, the strip-shaped elastic connecting member 25 is broken at the position where the notches 31 are provided, so that the secondary battery 24 can be easily separated to be disposed of.

Needless to say, when a primary battery and secondary battery are changed, the batteries can be changed while the sub board 29 is being pulled out from the opening 52, and then the changed batteries can again be accommodated in the casing 43.

In the above embodiments, explanations are given to the structures of the recording medium driving unit performing recording and reproducing such as HDD unit and electronic equipment having an image pick-up unit such as a digital camera; however, the present invention can be applied to such electronic equipment as a digital camera, portable telephone unit, portable recording/reproducing device, portable image pick-up device, PDA, or the like. Further, the component that is mounted on the sub board to be pulled out of the casing from the opening when changed or disposed of is not limited to a battery, and needless to say the component can be, for example, an electric component such as a capacitor for charging a flash of a camera or the like.

According to electronic equipment and the method for extracting a battery or electric component from the electronic equipment of the present invention, the area of the opening bored in the casing of the electronic equipment can be extremely small; there is no possibility of accidentally opening the lid, because the opening for extracting a secondary battery for the backup can be provided on a chassis, printed circuit or the like within the casing instead of providing the opening on any of the six surfaces constituting the casing; without the opening on any of the six surfaces, design of the casing will be more freely selected; and only with one action of removing the lid by a flat head or the like, the battery can be pulled out to be separated from the electronic equipment and disposed of by tugging the lid or board.

## Claims

1. Electronic equipment arranged to have a battery (24) extracted through an opening (21) provided on a part of a casing (20) or a chassis therefore comprising:
a main board (58) connected to said battery,
a strip-shaped elastic connecting member (25) joining said main board with said battery,
a sub board (29), on which said battery is mounted, connected to said strip-shaped elastic connecting member, and
a lid (22) for the opening (21), wherein the sub board is engaged with one of the lid (22) and the main board (58), and
by opening said lid of said opening, said battery on said sub board is arranged to be pulled with said lid out of said opening from said main board through said strip-shaped elastic connecting member.

2. Electronic equipment according to claim 1, wherein
said battery (24) is mounted in a detachable manner on said sub board (29) separately provided from said main board (58).

3. Electronic equipment according to claim 1 or 2, wherein
said battery (24) and said lid (22) are joined with a strip-shaped elastic member (25).

4. Electronic equipment according to claim 1, 2 or 3 wherein
said sub board (29) is temporarily held by said main board (58) or said lid (22).

5. Electronic equipment according to claim 1, 2, 3 or 4 wherein
an opening that is different from a primary battery inserting opening is provided within primary battery accommodating walls.

6. A method for extracting a battery (24) or electric component from electronic equipment, in which a battery is extracted through an opening (21) provided on a part of a casing (20) or chassis, wherein:
a sub board (29), on which a battery or electric component is mounted, provided on one end of a strip-shaped elastic connecting member connected to a main board (58), and is joined with one of a lid (22) for closing the opening (21) and the main board (58), and
by removing said lid that closes said opening, said battery or electric component is pulled with said sub board out of said opening away from said main board through said strip-shaped elastic connecting member.

## Patentansprüche

1. Elektronische Vorrichtung, die eine Batterie (23) hat, welche durch eine Öffnung (21), welche auf einem Teil eines Gehäuses (20) oder auf einem Chassis dafür vorgesehen ist, herausgezogen wird, welche aufweist:
eine Hauptplatte (58), welche mit der Batterie verbunden ist,
einen streifenförmiges elastisches Verbindungsteil (25), welches die Hauptplatte mit der Batterie verbindet,
eine Aufsteckkarte (29), auf welcher die Batterie befestigt ist, welche mit dem streifenförmigen elastischen Verbindungsteil verbunden ist, und
eine Klappe (22) für die Öffnung (21), wobei die Aufsteckkarte mit einem von der Klappe (22) und der Hauptplatte (58) angekuppelt ist, und
durch Öffnen der Klappe von der Öffnung die Batterie auf der Aufsteckkarte mit der Klappe aus der Öffnung von der Hauptplatte über das streifenförmige elastische Verbindungsteil herausgezogen wird.

2. Elektronische Vorrichtung nach Anspruch 1, wobei die Batterie (24) in einer lösbaren Weise auf der Aufsteckkarte (29) befestigt ist, welche separat von der Hauptplatte (58) vorgesehen ist.

3. Elektronische Vorrichtung nach Anspruch 1 oder 2,
wobei die Batterie (24) und die Klappe (22) mit einem streifenförmigen elastischen Teil (25) verbunden sind.

4. Elektronische Vorrichtung nach Anspruch 1, 2 oder 3, wobei die Aufsteckkarte (29) vorübergehend durch die Hauptplatte (58) oder die Klappe (22) gehalten wird.

5. Elektronische Vorrichtung nach Anspruch 1, 2, 3 oder 4, wobei
eine Öffnung, welche von der Hauptbatterie-Einführungsöffnung verschieden ist, innerhalb der Hauptbatterie-Unterbringungswände vorgesehen ist.

6. Verfahren zum Herausziehen einer Batterie (24) oder einer elektrischen Komponente von einer elektronischen Vorrichtung, wobei eine Batterie über eine Öffnung (21), welche auf einem Teil eines Gehäuses (20) oder Chassis vorgesehen ist, herausgezogen wird, wobei:
eine Aufsteckkarte (29), auf welcher eine Batterie oder eine elektrische Komponente befestigt ist, welche auf einem Ende eines streifenförmigen elastischen Verbindungsteils vorgesehen ist, welches mit einer Hauptplatte (58) verbunden ist, und mit einem von einer Klappe (22) zum Schließen der Öffnung (21) und der Hauptplatte (58) verbunden ist, und
durch Entfernen der Klappe, welche die Öffnung verschließt, die Batterie oder die elektrische Komponente mit der Aufsteckkarte aus der Öffnung weg von der Hauptplatte über das streifenförmige elastische Verbindungsteil herausgezogen wird.

## Revendications

1. Équipement électronique agencé pour extraire une batterie (24) à travers une ouverture (21) prévue sur une partie d'un boîtier (20) ou d'un châssis comportant par conséquent :
une plaque principale (58) reliée à ladite batterie,
un élément de liaison élastique en forme de bande (25) reliant ladite plaque principale à ladite batterie,
une sous-plaque (29), sur laquelle ladite batterie est montée, reliée audit élément de liaison élastique en forme de bande, et
un couvercle (22) pour l'ouverture (21), dans lequel la sous-plaque vient en contact du couvercle (22) et de la plaque principale (58), et
en ouvrant ledit couvercle de ladite ouverture, ladite batterie sur ladite sous-plaque est agencée pour être tirée avec ledit couvercle hors de ladite ouverture depuis ladite plaque principale par l'intermédiaire dudit élément de liaison élastique en forme de bande.

2. Équipement électronique selon la revendication 1, dans lequel ladite batterie (24) est montée de manière amovible sur ladite sous-plaque (29) prévue séparément de ladite plaque principale (58).

3. Équipement électronique selon la revendication 1 ou 2, dans lequel ladite batterie (24) et ledit couvercle (22) sont réunis par un élément élastique en forme de bande (25).

4. Équipement électronique selon la revendication 1, 2 ou 3, dans lequel ladite sous-plaque (29) est temporairement maintenue par ladite plaque principale (58) ou ledit couvercle (22).

5. Équipement électronique selon la revendication 1, 2, 3 ou 4, dans lequel une ouverture qui est différente d'une ouverture d'insertion de batterie primaire est munie de parois d'adaptation de batterie primaire.

6. Procédé d'extraction d'une batterie (24) ou d'un composant électrique depuis l'équipement électronique, dans lequel une batterie est extraite à travers une ouverture (21) prévue sur une partie d'un boîtier (20) ou d'un châssis, dans lequel :
une sous-plaque (29), sur laquelle une batterie ou un élément électrique est monté, prévue sur une extrémité d'un élément de liaison élastique en forme de bande relié à une plaque principale (58), et est réunie à l'un d'un couvercle (22) pour fermer l'ouverture (21) et de la plaque principale (58), et
en retirant ledit couvercle qui ferme ladite ouverture, ladite batterie ou le composant électrique est tiré avec ladite sous-plaque hors de ladite ouverture à partir de ladite plaque principale grâce audit élément de liaison élastique en forme de bande.
